# EUROPEAN PATENT SPECIFICATION

(11) **EP 0 459 177 B1**
(45) Date of publication and mention of the grant of the patent: **20.12.1995**
(21) Application number: 91107210.6
(22) Date of filing: 03.05.1991
(51) Int. Cl.: H01J 37/32, H05H 1/46

(54) **Solid state microwave generating array material, each element of which is phase controllable, and plasma processing systems**
Festkörper-mikrowellenerzeugendes Material matrixförmig gestaltet, von welchem jedes Element phasensteuerbar ist und Plasmabearbeitungssystem
Matériau solide générateur micro-onde sous forme matricielle, la phase de chaque élément de la matrice étant réglable et systèmes de traitement par plasma

(30) Priority: 01.06.1990 US 531828
(43) Date of publication of application: 04.12.1991
(73) Proprietor: International Business Machines Corporation, Armonk, N.Y. 10504 (US)
(72) Inventor: Cuomo, Jerome J., Lincolndale, N.Y. 10540 (US); Guarnieri, Charles R., Somers, N.Y. 10598 (US); Whitehair, Stanley J., Peekskill, N.Y. 10566 (US)
(74) Representative: Schäfer, Wolfgang, Dipl.-Ing.

(56) References cited:
- EP-A- 0 298 420
- EP-A- 0 432 573
- E.D. OSTROFF et al.:"Solid-state radar transmitters",1985 , Artech House , Norwood

## Description

The present invention relates generally to methods and apparatus using solid state microwave phased arrays to energize plasma and material processing apparatus. More particularly, it relates to the use of phase and amplitude controlled multiple antennas as the source of the microwave field used in the microwave process.

The present application is closely related to Patent Application US-A-450 343 of Cuomo et al., filed December 13, 1989 and entitled "Solid State Microwave Powered Material and Plasma Processing Systems" (corresponding to EP-A-0 432 573, published 19.06.91). This co-pending application discloses the basic concept of powering plasma and material processing systems with solid state microwave generators in lieu of tube-type microwave generators wherein the solid state generators are susceptible of greatly improved amplitude and phase control of the generator output as well as other economic and process control advantages occasioned by the use of the solid state devices. It is the availability and use of solid state microwave power sources which allow the present invention to be realized.

Materials and plasma processes continue to put demands on excitation methods. Recently, the high frequency excitation that is in the microwave region 300 MHz to 1 000 GHz has demonstrated the production of unique conditions for materials and plasma processes. For example, plasmas excited by microwaves can exist under conditions not easily achieved by other methods from about 0.133 Pa (10⁻³ Torr) to greater than atmospheric pressure. Coupled with magnetic fields, an Electron Cyclotron Resonance (ECR) region can be achieved producing intense plasmas in the range of from 1.33 to 1.33 · 10⁻⁵ Pa (10⁻² to 10⁻⁷ Torr).

Microwave power is very useful for generating plasmas for several reasons. It is a very efficient source of power for the free electrons. The time average power absorbed by these electrons is proportional to the electron density and the effective electric field squared. The effective electric field has a maximum value when the frequency of the power source approximately equals the effective electron collision frequency. (Reference 1 and 2). For gases and pressures typically used in plasma processing this electron collision frequency is in the microwave region of the spectrum. Most current plasma processing techniques (etching and deposition) currently use a frequency of 13.56 MHz, e.g., Diode sputtering, Reactive Ion Etching, etc.. For microwave radiation, the frequency is a few hundred to several thousand times this. The frequency commonly used in microwave plasma processing is 2.45 GHz. 2.45GHz is one of the designated Industrial Scientific Medical (ISM) oven heating frequencies. This is the frequency that is used in most commercially available home microwave ovens. Power supplies that operate at this frequency are readily available. They make use of a microwave tube called a magnetron to generate microwave energy. For a given power input, microwaves result in a greater electron density in the plasma than RF plasmas due to the frequency effects. Since the plasmas are almost neutral, this results in a higher ion density. This higher ion density results in higher processing rates, i.e., higher deposition and etching rates.

Another advantage of microwave processing is related to how the power is coupled to the plasma. Although there are many different ways of coupling microwave power to a plasma, (Ref. 3 and the references cited therein) they have one useful feature in common. The metal electrodes of the applicator are usually external to the vacuum system containing the plasma. The microwave power is coupled through a dielectric medium such as fused quartz or sapphire. This results in less contamination of the plasma and the parts being processed by the metal electrodes usually used with lower frequency processes and with reactive plasmas such as oxygen, chlorine, fluorine and the like. In addition to the decreased contamination, there is the elimination of the consumption of the metal electrodes by these reactive species.

Due to higher electron densities, microwave driven plasmas are more efficient sources of radicals that are used in plasma processing. By controlling the plasma conditions, particular species of radical production may be enhanced. In general, high pressure (>1.33 Pa (>10mT)) microwave discharges are good sources (i.e., high density) of radical species. (Ref. 4) Furthermore, in a microwave driven plasma, the temperature (energy) of the neutral gas component of the plasma can be much higher than in the more conventional lower frequency plasmas. Mechanisms, such as viscous heating of the neutral species by the energetic electrons, can result in higher processing reaction rates.

In addition to the denser plasmas that can be obtained with the higher frequency microwave power, there are resonant phenomena that occur that further enhance the coupling of microwave power to the plasma. Electron cyclotron resonance or ECR as it is called is an example of this enhanced coupling. For ECR the frequency of electron motion around a magnetic field direction (determined by the magnitude and direction of the magnetic field and the electron velocity) is the same as the frequency of the microwave radiation. For 2.45 GHz radiation a magnetic field with a magnitude of 70 KA/m (875 Oersteds) is needed. When this condition is met, there is an enhancement in the power absorbed by the free electrons of the plasma. With ECR enhancement greater than 10%, ionization is possible (Refs. 5 and 6).

In semiconductor and other plasma processing applications, intense microwave discharges are important in many applications such as deposition, etching, ashing, and ion beam generation. Many commercial systems are available to do microwave processing. Testing has shown that microwave technology has considerable advantage over existing technology. However, most existing microwave processing technology is limited in that it relies on vacuum tube technology, therefore, the limitations are imposed on the processes. Further, most plasma and material processing supplies are based on commercial home oven magnetrons operating at 2.45GHz and are therefore limited in the applications they can be used in, due to the inherent limitations of tube technology.

Microwave solid material processing per se is becoming increasingly important as a manufacturing processing technique. These processes include heating, curing, sintering, annealing or, in general, any process that directly couples microwaves into a solid or liquid material intending to change the chemical or physical structure of that material. Microwave excitation has several advantages over conventional techniques such as thermal or chemical processing. The microwave process is usually more efficient and faster. End point detection of the microwave process is usually available by monitoring, for example, the forward and reflected power (See for example Ref. 7). These advantages result from the direct coupling of the microwave energy into the chemical bond (usually a dipolar interaction). Because the energy is coupled internal to the system, the processing takes place at a faster rate than in conventional processing. For example, microwave curing of polymers results in lower thermal stress within the material than other techniques due to the direct energy coupling which reduces processing time. Further, as the material cures, it absorbs less energy except in regions still curing.

Microwave processing systems are available commercially. These systems have significant disadvantages that limit their use in some critical applications, again, through the use of oven magnetrons. Lack of microwave electromagnetic field uniformity is one disadvantage. Although some of these systems use resonant applicators or slotted waveguides, most of these systems are little more than multi-moded microwave ovens. In these systems, for regions of low electromagnetic field, the curing will be slower than in regions of high electromagnetic fields. Another important problem that currently available tube type microwave systems have is a lack of process control. In the typical oven type system it is very difficult to tell when a process is completed and to correct for problems in the process, such as overheating.

Two different types of microwave sources, solid state and vacuum tube, are currently known in the art. There are many different types of tube sources of microwave power, e.g., magnetrons, klystrons, gyrotrons, and the like (Ref. 8). Tubes have advantages in that they are capable of operating at higher frequencies and higher power levels. Power output and to a limited extent, frequency, can be adjusted with tube type sources. This can be done with dc bias voltages and magnetic fields. However, with the magnetron source, the most readily available and least expensive of the tube-type sources (for low power levels - less than several kW), the phase cannot be controlled. The other types of tube sources can be used with phase control, but they are very expensive and operate at the higher power levels of several tens of kW and more. Their main disadvantages are that they are large, bulky, very expensive, heavy and require high voltage from the anode to the cathode and high current for a filament. Tubes are also difficult to control and have short lifetimes.

In general all microwave tubes produce microwave power by converting the kinetic energy of an electron beam in a vacuum into electromagnetic energy. Different types of tubes employ different coupling structures to do this. No coupling structure is optimal, each has its advantages and disadvantages.

For example, traveling wave tubes use a helix coupling structure to convert the energy of the electron beam into electromagnetic energy. A klystron uses a series of cavity couplers to do the same thing. A magnetron bends the electron beam into a helix using a magnetic field, then converts the kinetic energy of the electron beam into microwave energy using a series of tuned cavities mounted radially around the center axis.

All of these tubes have similar advantages and disadvantages associated with their use when compared to solid state devices. All of these tubes require a source of electrons. In all microwave tubes, this is provided by a hot filament. To drive the filament, a low voltage high current supply is required. The filament causes problem in that it is very sensitive to vibration, produces large energy losses due to its inefficient nature, contributes to the heating of the tube and limits the lifetime of the tube. In general, filament failure is one of the leading causes of tube failure.

The second requirement of microwave tubes is an electron beam moving at a considerable velocity. This places more requirements on the design and use of the tubes. To accelerate the beam and keep it from spreading, a high potential is required in a high vacuum environment. This required potential, in turn, requires the use of a high voltage, low current supply. These supplies are expensive, bulky and difficult to operate. To prevent scattering of the beam, the tube is designed as a high vacuum chamber. This contributes greatly to the cost and complexity of the microwave tube. Most tubes have getters designed into the filament structure to maintain this vacuum. However, loss of vacuum integrity is the second most common failure mode in microwave tubes.

The third requirement in a microwave tube is a coupling structure to convert the energy in the electron beam into microwave power. As mentioned earlier, these structures vary in different tubes. However, all tubes share common problems with its use. These structures are very complex and difficult to machine. Typical machine tolerance is one ten thousands of an inch. Also microwave absorption in these structures is a significant source of heat in these tubes. This requires some method of cooling that adds to the cost, bulk and complexity of the tube and the overall supporting structure.

A noteworthy example of volume production economics is the home microwave oven operating at 2.45GHz. Because of the millions of tubes produced every year, manufacturing costs have been reduced to about five dollars per tube. These problems have been somewhat alleviated by spreading development and tooling costs over the large number of tubes produced. Through iterative improvements, problems such as cooling, lifetime and size have been addressed. Although, these tubes are reasonably compact and have reasonable lifetimes (e.g. 2000 hours or more), their power supplies are still bulky and require high voltage. However, they are available in large numbers due to the high demand for microwave ovens. However, the tubes are oscillators and thus operate only at 2.45GHz. Further, since they are in effect a "diode" device, they oscillate effectively at full power. This means that it is difficult to control the frequency or power output of these tubes.

It should be noted, in general, that a microwave tube can be built that can match the overall performance characteristics of any solid state device such as bandwidth and output power. However, it will cost approximately a thousand times more, be many times larger and heavier, consume more power, require complicated supply voltages, have limited lifetimes and have minimal controls of power output and other operating parameters such as phase, bandwidth and noise.

Except for military radar and communication applications, all microwave power generators in use currently are based on microwave tube technology. These tubes were developed during World War II and have changed very little functionally since then. These tubes can generate large amounts of power at frequencies up to the tera Hertz range. However, as stated previously, these tubes are heavy, bulky, inefficient, require high voltages and currents, expensive and have short lifetimes. All of these factors are very important in a manufacturing environment.

Because of all of the aforementioned problems with microwave tubes, most existing commercially available microwave supplies use oven magnetrons operating at 2.45GHz. This limits the equipment and the applications it can be used in.

Because of the previously mentioned problems, tubes are even more difficult to use in phased array application. However, solid state devices are ideal. They are easily phase and amplitude controlled and in addition can easily be adapted into large arrays. The power limitation of solid state devices can be overcome by simply adding more elements to the array.

No prior art is known to exist which discloses or suggests a solid state power source for a phased array of antennas producing a scanning microwave radiant energy beam in any sort of material on plasma processing apparatus.

Scanning phased array radars have been used for some years in both military and commercial radar systems. Such radars are particularly desirable because they are capable of extremely rapid scanning rates and require no, or a minimum of, moving mechanical parts. This latter feature is of special advantage in military applications where very rapid and carefully controlled changes in beam direction are required.

The prior art discussed in co-pending application US-A-450 343 (corresponding to EP-A-0 432 573, published 19.06.91) is equally applicable here and should be referenced for general background art concerning microwave power sources for material and plasma processing system etc.

It is a primary object of the present invention to provide an improved microwave powered phased array material/plasma processing system utilizing multiple phase controlled solid state microwave generators as the power source and emitting the microwave energy through an array of antennas.

It is another object of this invention to provide such a system wherein a plurality of such phase controlled solid state microwave sources may be utilized in an array to provide greatly enhanced electromagnetic field control within the reaction chamber, whereby selected movement of the composite field may be moved within the chamber.

It is another object of the invention to provide such a microwave powered phased array processing system wherein the phase, frequency, power and spectrum may be controlled to change coupling on the work surface to selectively energize different materials within the same system during essentially the same process step in addition to said movement.

Other objects, features and advantages of the present invention will be apparent from the following description of a preferred embodiment of the invention as set forth in the specification, drawings and claims.

The objects of the present invention are accomplished in general by using solid state microwave generators as excitation sources in an array of phase controlled antennas for material and plasma processes and, in particular, by a system as claimed in claims 1 and 7. In a preferred embodiment each radiative element in the phased (phase and amplitude controlled) array is driven by a separate solid state power source. This would be virtually impossible with the bulky and expensive tube type microwave sources currently used.

The inherent advantages of solid state generators where power and phase can be controlled at low power are significant with respect to the currently universally used vacuum tube technology. The relative ease with which phase can be controlled is, of course, critical to the present invention since the phase and amplitude of each radiative element in the phased array must be precisely controlled to obtain controlled movement/location of the array's composite power beam within a reactor chamber. Return signals in the reaction chamber can be easily sensed and or monitored to modify the generator outputs in response to process conditions. Additional measurable physical properties inherent in the process such as temperature, power, weight, color or the like that can be converted to a proportional voltage or current signal can be used by this technique for process control. These features are lacking in current vacuum tube microwave apparatus, such as microwave ovens.

FIG. 1 comprises a perspective view of a material/plasma vacuum processing chamber showing a phase antenna array located therein in accordance with the teachings of the present invention.

FIG. 2 comprises a functional block diagram of a suitable solid state microwave energization means for the phased antenna array illustrated in Fig. 1.

FIG. 3 comprises a cross sectional view of a simple dipole antenna such as would be suitable for use in the arrays illustrated in Figs. 1 and 4.

FIG. 4 comprises an illustration of another embodiment of an antenna array suitable for phase control which will provide a directed microwave energy beam.

FIG. 5 comprises a perspective view of a material processing system vacuum chamber similar to Fig. 1 illustrating yet another antenna array pattern wherein suitable phase control of the microwave energy source supplying each antenna will provide a controllable directed beam of microwave energy within the chamber.

FIG. 6 comprises an illustration of the details of construction of a solid state microwave amplifier/generator constructed in accordance with the teachings of the present invention showing a dipole radiative element attached thereto said amplifier/generator being suitable for use in the apparatus of Figs. 1 through 5.

FIGS. 7A and 7B comprise equivalent schematic diagrams of the electrical circuitry of two possible configurations for energizing the solid state microwave generator of the present invention and, which also illustrates the circuit elements which control the frequency and amplitude (power) of the output.

If there is an array of antennas radiating into free space, the vector addition of the electromagnetic radiation of each element or antenna gives the total electromagnetic field produced by the array. By controlling, specifically, the phase and, in some cases, the amplitude of each element, the electromagnetic fields of the individual elements can be made to constructively and destructively interfere with each other. If the phase is carefully controlled the constructive interference can be limited to a single direction and the destructive interference to the remainder of free space.

This "beam" of microwave energy can be used to process a surface or produce a plasma simply by scanning the beam across the area to be processed. Thus a "scanning" beam of microwave energy may be produced without any moving parts.

Using conventional microwave tubes, it would be very difficult, if not impossible, to construct a phased array for this application. Because each element must be driven by a separate phase and amplitude signal each element would require a separate power source. The advantages of solid state technology in terms of size and ease of use make it ideal for use in this application.

Solid state devices possess a number of advantages that particularly make them optimal microwave sources in plasma and material processing in general and especially for utilizing in phased arrays. They are small, efficient and only require easily obtained supply voltages and currents. They also can easily be incorporated in arrays and have the necessary phase and amplitude control at low power that permit adjustment to obtain desired field intensities throughout, for example, large reaction chambers. The power output from individual transistors may be increased simply by adding more elements to the array and adding the power through, for example, conventional transformer coupling methods.

The power and frequency at which solid state devices operate are increasing at a rapid rate. Because of this, solid state devices are replacing tubes in many communication and radar applications. Solid state devices have many properties that make their use advantageous. They are compact, light weight, efficient, low cost, operate at moderate supply voltages and currents. They are also vibration insensitive, have long lifetimes and are controllable to a much greater extent than tube type devices.

According to the teachings of the present invention, solid state devices are used as the source of microwave power or radiation for phased array plasma or material processing. These solid state devices are in effect microwave power sources for the process apparatus where the operating frequencies may be selected to optimize the processing to be done or to use existing microwave applicators. These solid state devices may be comprised of bipolar or field effect (i.e., MOSFET) transistors. Other solid state devices may be used. A more detailed description of such high frequency operable, high power output devices will be set forth subsequently. Conventional methods of power, current, voltage, and phase control may be used. The solid state devices may be any of the standard Class A, B, AB or C amplifiers or they may be of a resonant oscillator class all of which are well known in the electronics art.

For the purpose of phased array plasma processing, the plasma applicator is comprised of several elements where the electromagnetic field amplitude (not just power) and phase of the microwave radiation and its spatial frequency distribution may be controlled. By controlling these, the spatial distribution of the resultant microwave electromagnetic field may be controlled and the power absorbed in the plasma and/or material may be controlled. With the solid state power devices of the present invention, this control may be done with low power levels, then amplified in the high power solid state amplifiers to produce the power necessary to drive the process.

For an in depth description of the operation and controllability of Solid State microwave sources in general, see for example Ref. 9. For a discussion of the use of a plurality of relatively low power (e.g., 10 W,) devices to achieve a larger overall power output see Ref. 10 (pgs. 194-199). With a plurality of radiation sources in an array or multi element antenna, each element being identical and being driven at the same power level, the resultant electromagnetic field at a position in space is given by the vector sum of the electric/magnetic fields from each antenna. The resultant power density at that position is proportional to the appropriate product of the electric field and the magnetic field. (Ref. 3) This resultant power density can be related to the magnitude of the resultant electric field squared. If each of the sources has a random phase (or a phase that is slowly varying with time), the time average resultant power density is just the power density from one of the sources times the number of sources. If the phase of each source is adjusted so its electric field at a position is in phase with all of the other sources, the resultant power density at that position is proportional to the square of the magnitude of the electric field from one source times the square of the number of sources. An alternative implementation of this concept doesn't require all of the sources to be identical and the phases of each source can be varied to obtain a desired electric field distribution (thus a power density distribution).

As stated previously, it is only in recent years that transistor amplifiers capable of operating in the microwave region and capable of producing power output in the 10 - 100 W range have been developed. These devices developed primarily for military application such as RADAR and other communication systems have, as yet, seen little commercial application. Specific examples of solid state microwave source powered radar applications are set forth in great in Ref. 11. As will be appreciated, devices capable of withstanding higher operating temperatures have only recently been available. Circuits devices having the required distributed circuit parameters such as inductance, capacitance and amplification, which allows the devices to operate successfully at high frequency and power, have taken many years to develop. References 10 and 11 describe such devices and processes for making same. References 13, 15 and 16 describe the design of individual antennae to produce a desired field pattern. For simplicity dipole antennas are used as examples. Many other types of antennae are possible and are shown in Ref. 13. Reference 14 describes circuits used to produce phase and amplitude control at low power. This is an important area of electronic design for communication circuitry.

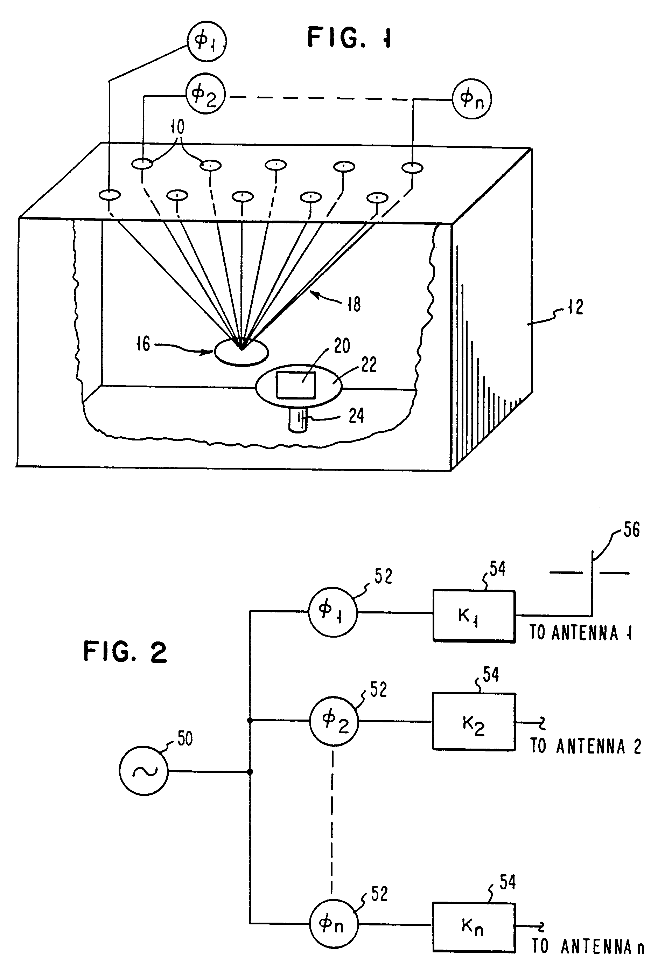

An example of a solid state microwave energized phased array plasma system is shown in FIG. 1. As stated previously, the present invention comprises an improvement or extension of previously filed application US-A-454 354 (corresponding to EP-A-0 432 573, published 19.06.91). The contribution of the present invention is the discovery that a plurality of individual microwave radiators may be utilized as a phased array with the net result that by careful and deliberate control of their individual phase relationships a concentrated, directed beam may be formed which may in turn be moved in free space by controlling the phase of the excitation being provided to each of the antennas of the array. Fig. 1 shows a very simple form of rectangular array wherein the individual antenna elements 10 are shown located on the top of a vacuum processing chamber 12. A 2 x 5 array of dipole antennas is arranged to constructively interfere with proper phase and amplitude control to produce an intense electro field at a certain point in space. A series of beams 18 is shown for diagrammatic purposes emanating from each antenna as a particular component of each of these would result in the intense field and resultant plasma 16, however, as will be readily understood each antenna in the array will produce its own propagation pattern which patterns constructively interfere at point 16 and destructively interfere at other points so that the electric field produced elsewhere would be relatively small.

A workpiece or target 20 is shown mounted on a support 22 which in turn is mounted on a holder or support 24 all as is well understood in the art. This system is shown in a highly simplified form. as stated previously the point of maximum field 16 will cause a plasma to be formed. By careful control of the phase (φ) and amplitude to each element n in the antenna array point 16 may be moved about in space e.g., across the support 22 to sweep one or more workpieces 20 mounted thereon. By this means a single processing setup could process a plurality of individual workpeices 20 located within the chamber whereas there might be insufficient power available to process them all concurrently. Accordingly, significant savings in processing time and material handling in the process would be achieved without any loss of control of the system.

In the apparatus of Fig. 1 it is apparent that only a plasma processing setup is shown e.g., the energy of the plasma per se causes physical changes to occur in the workpiece by heating etc. However, it will be readily understood by those skilled in the art that this system may readily be combined with other systems which introduce material into the chamber at the workpiece surface where materials are then treated and or the process enhanced by the formation of a microwave plasma. It will be further understood that these techniques are well known to those skilled in the art.

In Fig. 2 an overall function block diagram of a typical phased array signal generation and supply system is set forth. A single oscillator 50 provides a single master microwave signal for a series of n parallel phase shifters 52. Each of these phase shifters would be completely conventional in nature and would be provided with the capability of shifting the phase of a received signal a predetermined number of degrees with respect to the input [Ref. 14]. As will be apparent, each of the phase shifters, along with amplitude (gain) control, must be independently controllable and would in an optimized system be under the control of an appropriate computer or the like which would specify the amount of phase shift necessary by each phase shifter based upon predetermined programs for making the computations for either providing a static beam at some point in the chamber or for continuously sweeping the beam across the process area. For an expanded discussion of antenna theory of which discusses the theory and practice of phased antenna arrays, reference should be made to the book "Antenna Theory" by C. Balamis [Ref. 16].

The output of each of the n phase shifters 52 feeds a separate amplifier 54 of gain K. The gains are controlled in a manner similar to the phase control [Ref. 14]. The output of each amplifier 54 is then fed directly to its own individual antenna 56. In the simplest type of phased array system all of the amplifiers 54 would have the same amount of gain K. However, in more sophisticated systems it will be necessary to also control the gain of the respective amplifiers by means of an appropriate computer or the like to obtain more directionality or even vary the field intensity at certain places within a processing region.

From the preceding discussion it will be further seen that the present invention utilizing solid state amplifiers allows various operating parameters of the individual amplifiers such as gain to be readily varied which is not readily possible with known tube-type amplifiers.

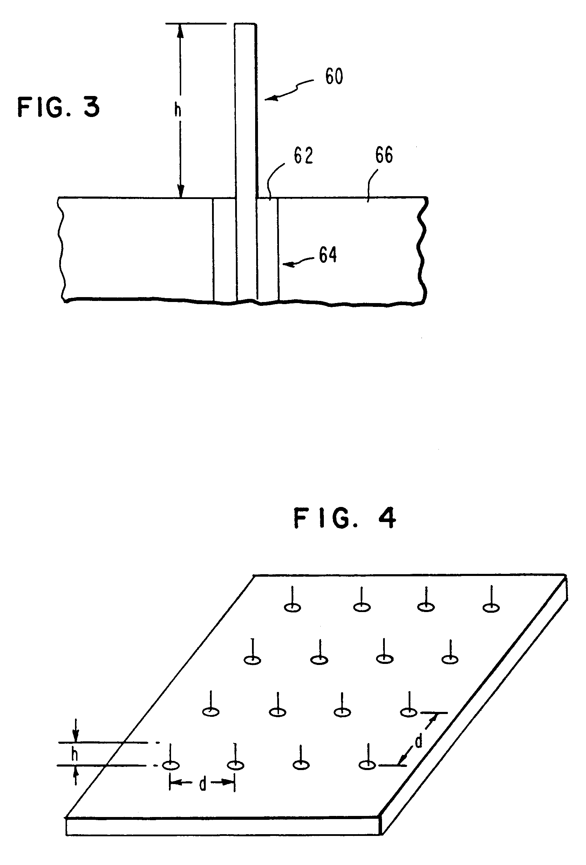

Fig. 3 is a cross-sectional view illustrating a simple coax fed dipole antenna. It comprises a central conductor 60 and insulating (dielectric) layer 62 and an outer conductor or shield 64. In the figure the coax cable is simply brought in through an aperture provided in the wall of the process chamber 66.

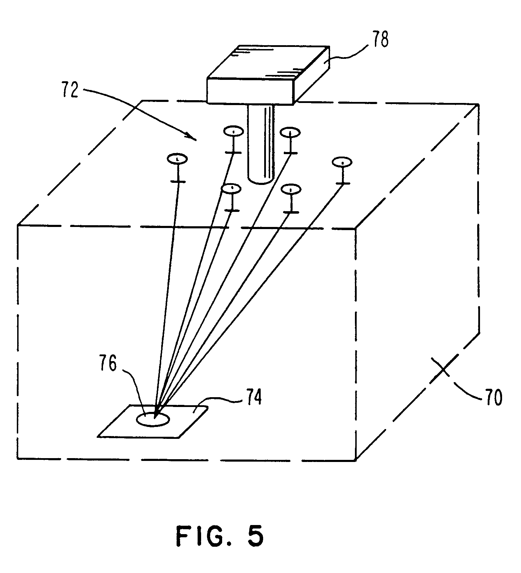

An inner surface of the chamber 66 becomes the ground plane and the extended portion of the central conductor becomes the radiative element of the antenna. The length h of the radiative element inserted into the chamber is normally chosen to be equal to λ which is the wavelength of the particular frequency of the source feeding the cable although it may be shorter. This antenna form, while one of the simplest types of antennas, is one of the best understood due to its mathematical simplicity. Other more complex antennas can be used but are difficult if not impossible to model mathematically. This is the type of antenna illustrated into the embodiments of Figs. 1 and 4. In Fig. 5 a "T" type of antenna is illustrated. For simplicity of explanation, dipole antennas have been used throughout this document. This is because it is the simplest kind of antenna. However, any kind of antenna will work. Refs. 13 and 15 present many examples.

In Fig. 4 an example of a somewhat different array configuration is shown, e.g., a 4x4 square array of coax-fed dipole antennas 10. These antennas are spaced apart a distance d, and are shown to have a dipole height or length h. Typically, d and h are chosen to be equal to λ or the wavelength of the driving excitation frequency.

As will be apparent, with the present invention the wavelength and thus the frequency of excitation of the phased array is considerably more critical than with a non phased array system even where a plurality of antennas may be used as discussed in co-pending Application US-A-450 343. This is due generally to the very precise relationship of the phases which must occur at each antenna to produce a particular radiation pattern. When the dipole is not an exact wavelength λ, the radiation pattern becomes quite distorted and more complicated to predict and it hence becomes much more difficult to control the shape of the resultant composite beam formed by the aggregation of antennas.

To return to the array of Figure 4 it will be noted that this array is essentially square as opposed to the elongated array e.g., 2x5 of Fig. 1. Generally with such phase controlled directional antenna systems, the more radiative elements in a given dimension, the better the control. Thus the array dimension of 5 elements would be along the process path in the chamber along which it is desired to have a scanning beam of microwave energy.

In Fig. 5 an example of a phased array is shown which has particular utility in treating polyimide films. This figure is similar to Fig. 1 in that it discloses an evacuated chamber 70, a six element antenna array 72, a chip carrier 74, and a chip or workpiece 76 coated with a polyimide film.

Also shown is an infrared detector or detector array 78, such as a camera, for monitoring the temperature or its spatial distribution or both. This information can then be used to control the spatial distribution of the microwave radiation.

As with the other embodiment disclosed the circular array constructively and destructively interferes appropriately to produce a very high intensity electromagnetic field which will form a plasma or a hot region on the chip or work surface coated with polyimide material. As with the other embodiments, an intense electromagnetic field is formed on a relatively small area of the target which couples into the material heating and curing it. By changing the phase and the amplitude of the driving radiation to the individual elements in a controlled manner, different surface regions of the target can be cured.

This is especially important with a polyimide since they have to be raised to a very high temperature, preferably very quickly to cure the material without harming the semiconductor structure and substrate.

The circular array is used in this case to provide better radial control of uniformity.

To synopsize, Ref. 14 is the best source of data for describing how the phase relationships of the signals to the various antennas of an array are controlled to produce a desired power node of a desired intensity at a desired location in space (in this case in a reaction chamber) with respect to the array. Ref. 11 provides details of how a given microwave oscillator may be controlled to vary the phase of the output microwave signal which in this case is fed to and becomes the input for the solid state hi-power microwave amplifiers all as disclosed and described herein.

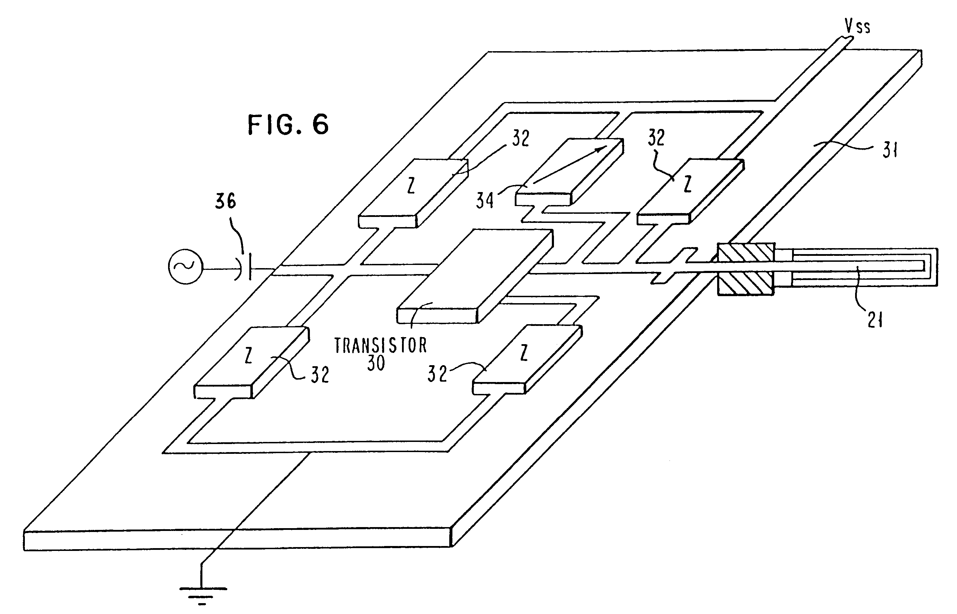

Fig. 6 illustrates the extent to which solid state-circuits can be integrated to produce a very compact, high power, solid state amplifier, thus illustrating one of the advantages of the present invention. Instead of building all of the components of the system as separate or discrete units, this figure illustrates how all of the amplifier elements could be built into a single high power system on a common substrate as is well known in the VLSI arts in general. These techniques can also be employed to produce IC microwave power amplifiers. Typically, oscillators are kept external. The solid state devices of the present invention are the amplifiers.

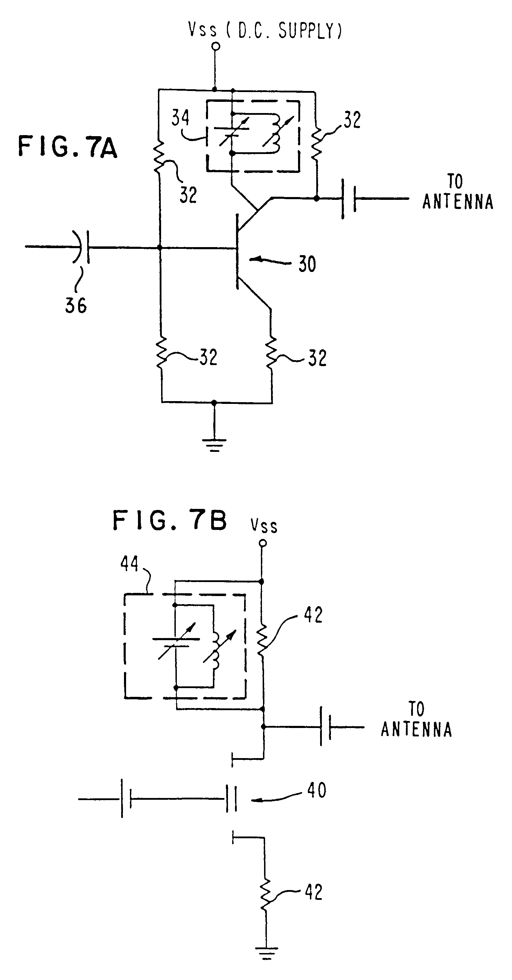

Reference should also be made to FIG. 7A, which is a schematic diagram of the solid state amplifier of FIG. 6 wherein, similar components have the same reference numbers. The power transistor 30, constructed as described above to operate at microwave frequency levels and several watts of power, is suitably fabricated on the substrate 31. The four load impedances 32 are also deposited on the substrate by well known techniques, as well as all the wiring. A conventional D.C. isolation capacitor 36 is also provided. A tunable element 34 is provided to sharpen the Q of the broad band amplifier but is not a frequency determining element per se. The frequency control is provided by control of the external low power oscillator 10.

The antenna 21 may be physically attached directly to the circuit substrate. This is illustrated schematically as the actual attachment could be done in a number of ways. This has the advantage that the only feed thrus necessary are for the DC supply voltage and these are easily and routinely constructed. This unit is then a small, compact plasma source that can easily be incorporated into the back of a larger ion beam source for example. More specifically it may be readily appreciated that such a structure is particularly well suited for use in the phased array microwave processing system of the present invention since it would be a simple matter to provide a separate amplifier to drive each antenna in the array. The phase shifter and associated controls therefor could either be placed between the output of each amplifier and its antenna, or, more practically, be placed between the oscillator and the amplifier as less power would have to be handled.

FIGS. 7A and 7B show examples of the circuit diagrams of two different types of wide band solid state amplifiers. FIG. 7A shows a bipolar transistor in a common emitter amplifier configuration. The tuning element 34 simply sharpens and shapes the amplifier Q response curve but as stated above is not a frequency determining element per se as will be well understood by those skilled in the art. The function of the various circuit elements of this configuration is the same as in common emitter amplifiers operating at lower frequency. It has the advantages of simplicity, high power levels and stability.

FIG. 7B shows an example of a MOSFET common drain amplifier showing the MOSFET 40, load resistors 42, and tunable element 44 all of which may be readily fabricated using solid state techniques. This circuitry also functions in an analogous manner to common drain amplifiers operating at lower frequencies. This amplifier has the advantages of high gain and efficiency. In this figure it is also assumed that an external oscillator is used. It would of course be possible, if desired to fabricate the oscillator on the same substrate or either of the high power amplifiers of FIGS. 7A and 7B.

While the IEEE article entitled "Silicon Bipolar Microwave Power Transistors" of R. Allison (Ref. 12) describes the details of the manufacture of suitable power transistors capable of operating in the microwave region, it is noted in general that the junctions must be very small to operate in the desired frequency range. This causes great power densities and heat generation within said smaller junctions which previous structures have heretofore been unable to handle. By keeping the junctions small stray circuit effects do not prevent their operating in the microwave region. The state of the art is continuing to improve these structures by reducing parasitic capacitance and making smaller junction regions of materials that can handle larger power densities.

There has thus been disclosed and described a novel solid state microwave powered phased array material/plasma processing system which is believed to have great promise in producing novel solid state electronic devices and the like utilizing various plasma processing methods.

Utilizing the principles of the present invention, extremely precise control of the plasma parameters and distribution may be achieved at much less expense than with conventional tube type microwave power sources such as magnetrons.

Also, the use of the phased array allows much more complex and otherwise more time consuming and expensive processes to be carried out in a single chamber and a single process set up. The invention also allows higher power concentrations to be attained in a given region of the process chamber on the substrate than would be possible if a given amount of power had to be uniformly spread over an entire process region.

As technology improves and even more powerful high frequency amplifiers become available, the advantages of the present invention will become even more significant.

### List of References

1. Jes Asmussen, Journal of Vacuum Science and Technology, A7, (1989) 883.
2. B. E. Cherrington, Gaseous Electronic and Gas Lasers (Pergamon, New York, 1966).
3. John David Jackson, "Classical Electrodynamics", John Wiley & Sons (1975), pp. 209-268.
4. Chemical Effects of Microwave Discharges, James P. Wightman, Proceedings of IEEE, Vol. 62, 1 January 1974.
5. "Handbook of Ion Beam Processing Technology", Edited by J. J. Cuomo and S. M. Rossnagel and H. R. Kaufman, Chapter 3 "ECR Ion Sources" by W. Holber., Notes, 1989.
6. "Handbook of Plasma Processing Technology", Edited by S. M. Rossnagel, J.J. Cuomo and W. Westwood, Chapter 11, "Electron Cyclotron Resonance Microwave Discharge For Etching and Thin Film Deposition", by J. Asmussen, Noyes, 1989.
7. "Microwave Heating and Dielectric Diagnosis Technique in a Single-Mode Resonant Cavity", J. Jow, M. Hawley, M. Finzel and J. Asmussen, Review of Scientific Instruments Vol. 60, No. 1, January 1989.
8. "Microwave Tubes", A. Gilmour, Artech House, Inc., 1986.
9. H. Krauss, C. Bostian and F. Raab, "Solid State Radio Engineering", J. Wiley and Sons, 1980.
10. "Applications of GaAs MESFETS", Edited by R. Soares, J. Graffeuil and J. Obregon, Artech House, Inc., 1983.
11. E. Ostroff, M. Borkowski, H. Thomas and J. Curtis, "Solid-State Radar Transmitters", Artech House, Inc., 1985.
12. R. Allison, "Silicon Bipolar Microwave Power Transistors", IEEE Trans, Vol. MTT-27, No: 5, May 1989, pp. 415-422.
13. Classical Electromagnetic Radiation by Jerry B. Marion, Academic Press, 1965.
14. Microwave Semiconductor Engineering by Joseph F. White, Van Nostrand Reinhold Company 1982.
15. Microwave Antenna Theory and Design, Samuel Siler, Peter Peregrinus Ltd., 1984.
16. C. Balanis, "Antenna Theory, Analysis and Design"; Harper and Row, N.Y., 1982.

## Claims

1. A microwave powered material/plasma processing system with at least a reaction chamber (12) for holding a process workpiece (20) and means for placing a requisite electrical bias on the workpiece (20), comprising:
multiple solid state microwave generators each including a solid state amplifier (54) connected thereto for providing power to said system and mounted to directly introduce microwave power into said reaction chamber (12) containing said workpiece (20) via direct radiating antennas (10) mounted to form an array, in said chamber (12),
means for measuring the amplitude and power of the microwave radiation in the chamber (12) from the array at predetermined locations therein, and
means for controlling the phase and amplitude of the output of each of said microwave generators, each said output being connected to respective solid state amplifiers (54) each of which supplies power to a single antenna (56) of said array to effect a predetermined distribution of microwave power from said array to predetermined locations within said chamber (12).

2. The microwave powered material/plasma processing system as set forth in claim 1 including means (52) for continuously varying the phase of the output of each of said solid state amplifiers (54) with respect to each other to effect movement of an electromagnetic field power node produced by said array within said chamber (12).

3. The microwave powered processing system as set forth in claim 1 or 2 wherein said solid state microwave generators each comprise a separate low power oscillator whose phase and amplitude are easily controlled and a separate high power amplifier capable of operating at microwave frequencies.

4. The microwave powered processing system as set forth in one or more of the preceding claims 1 to 3, wherein said multiple antennas (10) are each physically attached to a solid state microwave amplifier substrate and are electrically connected to the amplifier output and protrude through an aperture provided in the process chamber (12).

5. The microwave powered plasma processing system as set forth in one or more of the preceding claims 1 to 4 including means for monitoring the power produced by each said solid state microwave amplifier (54) and phase controlled antenna (56) and means responsive thereto for controlling the power output and locations of the composite field.

6. The microwave powered plasma processing system as set forth in one or more of the preceding claims 1 to 5, wherein the phased array of radiating antennas (56) in the processing chamber (12) is organized into a square array, a rectangular array or a circular array.

7. A microwave powered material/plasma processing system with at least a reaction chamber (12) for holding a process workpiece (20) and means for placing a requisite electrical bias on the workpiece, comprising:
a single solid state microwave oscillator having a plurality of solid state amplifiers (54) connected thereto for providing power to said system and mounted to directly introduce microwave power into said reaction chamber (12) containing said workpiece (20) via direct radiating antennas (10) mounted to form an array, in said chamber (12),
means for measuring the amplitude and power of the microwave radiation in the chamber (12) from the array at predetermined locations therein, and
separate means for controlling the phase and amplitude of the output of said microwave oscillator and connected individual inputs of said plurality of solid state amplifiers (54) each of which supplies power to a single antenna (56) of said array whereby the phase and amplitude of the outputs of each said solid state amplifier (54) is separately controllable to effect a predetermined distribution of microwave power from said array to predetermined locations within said chamber (12).

## Patentansprüche

1. Mikrowellenbetriebenes Material/Plasmabearbeitungssystem mit wenigstens einer Reaktionskammer (12) zum Halten eines Bearbeitungswerkstücks (20) und Mitteln zum Anlegen einer notwendigen elektrischen Vorspannung an dem Werkstück (20), das beinhaltet:
mehrere Festkörper-Mikrowellengeneratoren, von denen jeder einen Festkörper-Verstärker (54) beinhaltet, der mit demselben zur Leistungsversorgung des Systems verbunden ist, und so angebracht ist, daß über direkte Strahlungsantennen (10) in der Kammer, die so angebracht sind, daß sie eine regelmäßige Anordnung bilden, Mikrowellenleistung direkt in die Reaktionskammer (12) eingebracht wird, die das Werkstück (20) enthält,
Mittel zum Messen der Amplitude und der Leistung der Mikrowellenstrahlung in der Kammer (12) von der regelmäßigen Anordnung an vorgegebenen Stellen in derselben, und
Mittel zum Steuern der Phase und der Amplitude des Ausgangs von jedem der Mikrowellengeneratoren, wobei jeder Ausgang mit jeweiligen Festkörper-Verstärkern (54) verbunden ist, von denen jeder eine einzelne Antenne (56) der regelmäßigen Anordnung mit Leistung versorgt, um eine vorgegebene Verteilung von Mikrowellenleistung von der regelmäßigen Anordnung an vorgegebenen Stellen innerhalb der Kammer (12) zu bewirken.

2. Mikrowellenbetriebenes Material/Plasmabearbeitungssystem nach Anspruch 1, das Mittel (52) zum kontinuierlichen Variieren der Phase des Ausgangs von jedem der Festkörper-Verstärker (54) relativ zueinander beinhaltet, um eine Bewegung eines durch die regelmäßige Anordnung innerhalb der Kammer (12) erzeugten Leistungsknotens des elektromagnetischen Feldes zu bewirken.

3. Mikrowellenbetriebenes Bearbeitungssystem nach Anspruch 1 oder 2, wobei die Festkörper-Mikrowellengeneratoren jeweils einen separaten Oszillator mit niedriger Leistung, dessen Phase und Amplitude leicht zu steuern sind, und einen separaten Hochleistungsverstärker beinhalten, der in der Lage ist, bei Mikrowellenfrequenzen zu arbeiten.

4. Mikrowellenbetriebenes Bearbeitungssystem nach einem oder mehreren der vorhergehenden Ansprüche 1 bis 3, wobei die mehreren Antennen (10) jeweils an einem Festkörper-Mikrowellenverstärkersubstrat physisch angebracht und mit dem Verstärkerausgang elektrisch verbunden sind und durch eine Öffnung, die in der Prozeßkammer (12) vorgesehen ist, hervorragen.

5. Mikrowellenbetriebenes Plasmabearbeitungssystem nach einem oder mehreren der vorhergehenden Ansprüche 1 bis 4, das Mittel zum Überwachen der Leistung, die von jedem Festkörper-Verstärker (54) und jeder phasengesteuerten Antenne (56) erzeugt wird, und darauf ansprechende Mittel beinhaltet, um die Leistungsabgabe und -positionen des zusammengesetzten Feldes zu steuern.

6. Mikrowellenbetriebenes Plasmabearbeitungssystem nach einem oder mehreren der vorhergehenden Ansprüche 1 bis 5, wobei die phasenabgestimmte regelmäßige Anordnung von Strahlungsantennen (56) in der Prozeßkammer (12) in einer quadratischen Anordnung, einer rechtwinkligen Anordnung oder einer kreisförmigen Anordnung arrangiert ist.

7. Mikrowellenbetriebenes Material/Plasmabearbeitungssystem mit wenigstens einer Reaktionskammer (12) zum Halten eines Bearbeitungswerkstücks (20) und Mitteln zum Anlegen einer notwendigen elektrischen Vorspannung an dem Werkstück, das beinhaltet:
einen einzelnen Festkörper-Mikrowellenoszillator, der eine Mehrzahl von Festkörper-Verstärkern (54), die mit demselben zur Leistungsversorgung des Systems verbunden sind, aufweist und so angebracht ist, daß über direkte Strahlungsantennen (10) in der Kammer (12), die so angebracht sind, daß sie eine regelmäßige Anordnung bilden, Mikrowellenleistung direkt in die Reaktionskammer (12) eingebracht wird, die das Werkstück (20) enthält,
Mittel zum Messen der Amplitude und der Leistung der Mikrowellenstrahlung in der Kammer (12) von der regelmäßigen Anordnung an vorgegebenen Stellen in derselben, und
separate Mittel zum Steuern der Phase und der Amplitude des Ausgangs des Mikrowellenoszillators und verbundene individuelle Eingänge der Mehrzahl von Festkörper-Verstärkern (54), von denen jeder eine einzelne Antenne (56) der regelmäßigen Anordnung mit Leistung versorgt, wodurch die Phase und die Amplitude der Ausgänge von jedem der FestkörperVerstärker (54) separat steuerbar ist, um eine vorgegebene Verteilung von Mikrowellenleistung von der regelmäßigen Anordnung an vorgegebenen Stellen innerhalb der Kammer (12) zu bewirken.

## Revendications

1. Système de traitement de matériau/plasma alimenté à micro-ondes avec au moins une chambre de réaction (12) pour contenir une pièce à travailler de traitement (20) et un moyen pour placer une polarisation électrique nécessaire sur la pièce à travailler (20), comprenant:
de multiples générateurs de micro-ondes à semiconducteur comportant chacun un amplificateur (54) à semiconducteur connecté à ceux-ci pour fournir de la puissance audit système et montés pour introduire directement la puissance micro-ondes dans ladite chambre à réaction (12) contenant ladite pièce à travailler (20) par l'intermédiaire d'antennes (10) de rayonnement direct montées pour former un réseau, dans ladite chambre (12),
un moyen pour mesurer l'amplitude et la puissance du rayonnement micro-ondes dans la chambre (12) à partir du réseau en des emplacements prédéterminés à l'intérieur de celle-ci, et
un moyen pour commande la phase et l'amplitude de la sortie de chacun desdits générateurs de micro-ondes, chacune desdites sorties étant connectée aux amplificateurs à semiconducteur respectifs (54) chacun d'eux appliquant de la puissance à une seule antenne (56) dudit réseau pour effectuer une répartition prédéterminée de puissance micro-ondes à partir du réseau en des emplacements prédéterminés à l'intérieur de ladite chambre (12).

2. Système de traitement de matériau/plasma alimenté par micro-ondes selon la revendication 1 comportant un moyen (52) pour faire varier en continu la phase de la sortie de chacun desdits amplificateurs à semiconducteur (54) par rapport les uns aux autres pour effectuer le déplacement d'un noeud de puissance d'un champ électromagnétique par ledit réseau à l'intérieur de ladite chambre (12).

3. Système de traitement alimenté par micro-ondes selon la revendication 1 ou 2 dans lequel lesdits générateurs de micro-ondes à semiconducteur comprennent chacun un oscillateur basse puissance séparé dont la phase et l'amplitude sont aisément commandées et un amplificateur haute puissance séparé capable de fonctionner aux fréquences micro-ondes.

4. Système de traitement alimenté par micro-ondes selon l'une ou plusieurs des revendications précédentes 1 à 3, dans lequel lesdites multiples antennes (10) sont chacune fixées physiquement à un substrat d'amplificateur à micro-ondes à semiconducteur et sont électriquement connectées à la sortie de l'amplificateur et font saillie d'une ouverture pratiquée dans la chambre de traitement (12).

5. Système de traitement de plasma alimenté par micro-ondes selon l'une ou plusieurs des revendications précédentes 1 à 4 comportant un moyen pour contrôler la puissance produite par chacun desdits amplificateurs (54) à micro-ondes à semiconducteur et une antenne (56) commandée en phase et un moyen sensible à celle-ci pour commander la puissance de sortie et les emplacements du champ composite.

6. Système de traitement de plasma alimenté par micro-ondes selon l'une ou plusieurs des revendications 1 à 5, dans lequel le réseau phasé d'antennes de rayonnement (56) dans la chambre de traitement (12) est organisé en un réseau carré, un réseau rectangulaire ou un réseau circulaire.

7. Système de traitement de matériau/plasma alimenté par micro-ondes avec au moins une chambre de réaction (12) pour contenir une pièce à travailler (20) de traitement et un moyen pour placer une polarisation électrique nécessaire sur la pièce à travailler, comprenant:
un oscillateur unique à micro-ondes à semiconducteur comportant une pluralité d'amplificateurs à semiconducteur (54) connectés à celui-ci pour fournir de la puissance audit système et monté pour introduire directement une puissance micro-ondes dans ladite chambre de réaction (12) contenant ladite pièce à travailler (20) par l'intermédiaire d'antennes de rayonnement direct (10) montées pour former un réseau, dans ladite chambre (12),
un moyen pour mesurer l'amplitude et la puissance du rayonnement micro-ondes dans la chambre (12) à partir du réseau en des emplacements prédéterminés à l'intérieur de celle-ci, et
un moyen séparé pour commander la phase et l'amplitude de la sortie dudit oscillateur à micro-ondes et connecté à des entrées individuelles de ladite pluralité d'amplificateurs à semiconducteur (54) chacun d'eux appliquant de la puissance à une seule antenne (56) dudit réseau, grâce à quoi la phase et l'amplitude des sorties de chacun desdits amplificateurs à semiconducteur (54) est séparément commandable pour effectuer une répartition prédéterminée de puissance micro-ondes à partir dudit réseau en des emplacements prédéterminés à l'intérieur de ladite chambre (12).
